# EUROPEAN PATENT APPLICATION

(11) **EP 3 223 427 A1**
(43) Date of publication of application: **27.09.2017**
(21) Application number: 17162759.9
(22) Date of filing: 24.03.2017
(51) Int. Cl.: H03F 3/217, H03F 1/32, H03F 3/181

(54) **BTL OUTPUT SELF-OSCILLATING CLASS D AMPLIFIER**

(30) Priority: 25.03.2016 JP 2016062852
(71) Applicant: YAMAHA CORPORATION, 430-8650 Shizuoka Hamamatsu-shi (JP)
(72) Inventor: Togawa, Takeshi, Shizuoka, 430-8650 (JP); Noro, Masao, Shizuoka, 430-8650 (JP)
(74) Representative: Hoffmann Eitle

(57) **Abstract**

A Bridge-Tied Load output self-oscillating class D amplifier includes a comparator receives an input signal from a signal input circuit at a second input terminal and outputs a positive-phase pulse width modulation signal and a reverse-phase pulse width modulation signal by comparing voltages of the two input terminal, first and second switching circuits power-amplifies the reverse-phase pulse width modulation signal and the positive-phase pulse width modulation signal, a first low-pass filter extracts a first output signal from the reverse-phase pulse width modulation signal, a second low-pass filter extracts a second output signal from the positive-phase pulse width modulation signal, a subtractor calculates a difference between the first and second output signals and output a difference signal, and a first feedback circuit feeds back the difference signal to the second input terminal of the comparator.

## Description

### BACKGROUND OF THE INVENTION

### 1. Field of the Invention

The present disclosure relates to a BTL (bridge-tied load) output self-oscillating class D amplifier.

### 2. Description of the Related Art

Self-oscillating class D amplifiers have been known conventionally as a type of amplifier for power-amplifying signals such as audio signals.

JP-B-61-21007 described below discloses a self-oscillating class D amplifier including an integrator for integrating an audio signal input thereto; a comparator for comparing the output of the integrator with the feedback output from a first feedback circuit and for outputting a PWM (pulse width modulation) signal; a switching circuit for power-amplifying the PWM signal coming from the comparator; a low-pass filter (LPF) for removing the carrier component from the PWM signal output from the switching circuit and for demodulating the power-amplified audio signal; a first feedback circuit for feeding back the output of the LPF to the inverting input terminal of the comparator; and a second feedback circuit for feeding back the output of the LPF to the inverting input terminal of the integrator. The loop circuit starting from the comparator, passing through the LPF and returning from the LPF to the input terminal of the comparator through the first feedback circuit self-oscillates at a frequency f0 at which the phase delay of the loop circuit is 180 degrees. The self-oscillation frequency f0 can be adjusted by changing the delay of the first feedback circuit. Negative feedback is applied to the audio band and the gain of the amplifier in the audio band is determined by the feedback route of the second feedback circuit.

Furthermore, BTL (bridge-tied load) type amplifiers have been known conventionally. The BTL type is a type in which a first amplifier power-amplifies an input signal in the same phase and outputs a positive-phase output signal, a second amplifier power-amplifies the input signal in reverse phase and outputs a reverse-phase output signal, and a load (speaker) is connected so as to bridge the outputs of the two amplifiers. The output voltage of this type of amplifier is doubled and the output is quadrupled theoretically.

JP-A-2003-110375 described below discloses a self-oscillating class D amplifier in which the BLT output_is used in the output stage of the amplifier. For example, Fig. 1 in JP-A-2003-110375 discloses a BTL output self-oscillating class D amplifier in which one of the output signals (PWM signals) of a comparator is power-amplified by a first switching circuit and supplied to one of the input terminals of a speaker via a first LPF and the other output signal is power-amplified by a second switching circuit via an inverter for signal inversion and supplied to the other input terminal of the speaker via a second LPF. This self-oscillating class D amplifier has a configuration in which feedback is applied from each of the first and second switching circuits to the comparator, whereby self-oscillation is performed.

In the circuit described in JP-B-61-21007, in the case of designing an amplifier having high overall gain and high output power, it is assumed that high voltage swing (for example, ±100 V) may occur in the output voltage. In such a case, input voltage of fairly large swing is assumed to be input to the input side. Hence, the input voltage applied to the comparator has large swing. Furthermore, since the amplifier is a self-oscillation type, a feedback signal for self-oscillation fed back from the output side is applied to the input terminal of the comparator. As a result, there is a problem that a semiconductor device having a fairly high breakdown voltage is required to be used as the comparator.

In the circuit described in JP-A-2003-110375, the respective outputs of the two switching circuits are fed back to the comparator to attain self-oscillation. Hence, there is a problem that since two loop circuits oscillating at self-oscillation frequencies higher than the frequency band of an input audio signal that is supposed to be power-amplified are formed, it is difficult to control the self-oscillation (the oscillation operation becomes unstable).

### SUMMARY OF THE INVENTION

An object of the present disclosure is to suppress voltage swing at the input terminals of a comparator for performing pulse width modulation and to attain stable self-oscillation operation in a BTL output self-oscillating class D amplifier.

In order to attain the above-mentioned object, there is provided a Bridge-Tied Load output self-oscillating class D amplifier comprising:
a signal input circuit;
a comparator, having a first input terminal being grounded and an second input terminal, and configured to receive an input signal coming from the signal input circuit at the second input terminal, and output a positive-phase pulse width modulation signal and a reverse-phase pulse width modulation signal with respect to the input signal by comparing voltages of the first input terminal and the second input terminal;
a first switching circuit configured to power-amplify the reverse-phase pulse width modulation signal;
a first low-pass filter configured to extract a first output signal from the power-amplified reverse-phase pulse width modulation signal;
a second switching circuit configured to power-amplify the positive-phase pulse width modulation signal;
a second low-pass filter configured to extract a second output signal from the power-amplified positive-phase pulse width modulation signal;
a subtractor configured to calculate a difference between the first output signal and the second output signal and output a difference signal; and
a first feedback circuit configured to feed back the difference signal to the second input terminal of the comparator.

With the present disclosure, since the first input terminal of the comparator for performing pulse width modulation is grounded and the sum signal of the signal from the signal input circuit and the feedback signal from the first feedback circuit for self-oscillation is input to the second input terminal, the voltage swings at both the inputs of the comparator can be suppressed, whereby the present disclosure is advantageous in that a semiconductor device having a high breakdown voltage is not required to be used as the comparator. Furthermore, since the difference between the two BTL-type positive and negative output signals is calculated using the subtractor and the difference signal is fed back via the first feedback circuit, a single self-oscillation loop is formed, whereby control is made easy and the self-oscillation becomes stable. Moreover, since the bypass circuit for feeding back at least one of the BTL-type output signals without passing through the subtractor is provided, furthermore stable self-oscillation operation can be attained.

### BRIEF DESCRIPTION OF THE DRAWINGS

Fig. 1 is a circuit diagram of a self-oscillating class D amplifier according to an embodiment of the present disclosure; and
Fig. 2 is a frequency characteristic diagram illustrating the operation of the bypass circuit of the amplifier.

### DETAILED DESCRIPTION OF THE EXEMPLARY EMBODIMENTS

An embodiment according to the present disclosure will be described below referring to the accompanying drawings.

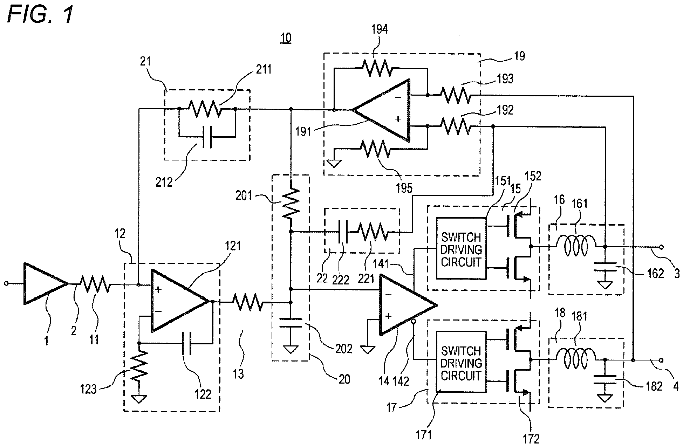

Fig. 1 is a circuit diagram of a self-oscillating class D amplifier 10 according to the embodiment of the present disclosure. A buffer 1 amplifies an input audio signal in positive phase (in a non-inverting way) or in negative phase (in an inverting way) and delivers the amplified signal to the input terminal 2 of the amplifier 10. Numeral 3 designates the first output terminal of the amplifier 10, and numeral 4 designates the second output terminal thereof.

The amplifier 10 includes a first resistor 11, an non-inverting analog integration circuit 12, a second resistor 13, a comparator 14, a first switching circuit 15, a first low-pass filter (LPF) 16, a second switching circuit 17, a second LPF 18, an analog subtractor 19, a first feedback circuit 20, a second feedback circuit 21, and a bypass circuit 22. The first resistor 11 and the non-inverting analog integration circuit 12 are collectively referred to as a signal input circuit.

The non-inverting analog integration circuit 12, configured by an operational amplifier 121, a capacitor 122 and a resistor 123, integrates the audio signal delivered to the input terminal 2 of the amplifier 10 (the input terminal of the integration circuit 12) and containing a second feedback signal fed back by the second feedback circuit 18 and then outputs the integrated signal obtained as the result of the integration to the comparator 14. The amplifier 10 herein operates as a single inverting amplifier whose gain in the audio band is determined by the first resistor 11 and a resistor 211, and the non-inverting input terminal of the operational amplifier 121 is grounded virtually. Hence, an ordinary semiconductor device having a low breakdown voltage can be used as the operational amplifier 121. In the second feedback circuit 21, a capacitor 212 is connected in parallel with the resistor 211, whereby the phase of the second feedback signal is advanced and the operation of the amplifier 10 is stabilized (phase compensation).

The second input terminal (inverting input terminal) of the comparator 14 receives the integrated signal coming from the integration circuit 12 and containing a first feedback signal fed back by the first feedback circuit 20. The comparator 14 compares the integrated signal with the reference voltage (the ground voltage) at the first input terminal (non-inverting input terminal) of the comparator 14, thereby generating a reverse-phase PWM signal that is obtained by PWM-modulating the audio signal delivered to the input terminal 2 in reverse phase and outputting the PWM signal from a non-inverting output terminal 141 of the comparator 14. Furthermore, the comparator 14 generates a positive-phase PWM signal that is obtained by PWM-modulating the audio signal in positive phase and outputs the PWM signal from an inverting output terminal 142. The reverse-phase PWM signal from the non-inverting output terminal 141 of the comparator 14 is input to the first switching circuit 15, and the positive-phase PWM signal from the inverting output 142 of the comparator 14 is input to the second switching circuit 17.

The first switching circuit 15 includes a switch driving circuit 151 and a switch circuit 152. The switch driving circuit 151 drives the switch circuit 152 based on the reverse-phase PWM signal coming from the comparator 14. The switch circuit 152 is configured by two power transistors (for example, FETs) connected to positive and negative power supplies. When driven by the switch driving circuit 151, the switch circuit 152 amplifies electric power of the PWM signal, or in other words power-amplifies the reverse-phase PWM signal and outputs the power-amplified signal. The first LPF 16, configured by an inductor 161 and a capacitor 162, removes the carrier component from the PWM signal output from the switch circuit 152, demodulates (extracts) the power-amplified reverse-phase audio signal, and outputs the demodulated signal from a first output terminal 3 of the amplifier 10.

The configuration of the second switching circuit 17 is the same as that of the first switching circuit 15, and the configuration of the second LPF 18 is the same as that of the first LPF 16. The second switching circuit 17 power-amplifies the positive-phase PWM signal coming from the comparator 14, and the second LPF 18 demodulates (extracts) the power-amplified positive-phase audio signal from the power-amplified positive-phase PWM signal, and outputs the demodulated signal from a second output terminal 4. The first output terminal 3 and the second output terminal 4 of the amplifier 10 are two BTL-type positive and negative outputs, and the user connects a load, such as a speaker, therebetween. In a case where the buffer amplifies the input audio signal in positive way, the negative-phase audio signal should be supplied to a positive terminal (usually red) of the speaker and the positive-phase audio signal should be supplied to a negative terminal (usually black) of the speaker. In a case where the buffer amplifies the input audio signal in negative way, the positive-phase audio signal should be supplied to the positive terminal of the speaker and the negative-phase audio signal should be supplied to a negative terminal of the speaker.

The analog subtractor 19 includes an operational amplifier 191 and resistors 192 to 195. The operational amplifier 191 receives at its non-inverting input terminal the reverse-phase audio signal from the first LPF 16 via the resistor 192. The operational amplifier 191 receives at its inverting input terminal the positive-phase audio signal from the second LPF 18 via the resistor 193. The subtractor 19 calculates the voltage difference between the reverse-phase audio signal and the positive-phase audio signal and outputs a difference signal corresponding to the voltage difference. The difference signal output from the subtractor 19 is fed back as the first feedback signal to the second input terminal (to the integrated signal) of the comparator 14 by the first feedback circuit 20 and is also fed back as the second feedback signal to the audio signal input terminal of the integration circuit 12 by the second feedback circuit 21.

The first feedback circuit 20 includes, for example, a resistor 201, one end of which is connected to the output of the subtractor 19 and the other end of which is connected to the second input terminal of the comparator 14, and a capacitor 202, one end of which is connected to the second input terminal of the comparator 14 and the other end of which is grounded. The first feedback circuit 20 delays the difference signal coming from the subtractor 19 and feeds back the delayed difference signal to the integrated signal on the second input side of the comparator 14. The amplifier 10 oscillates as a self-oscillating class D amplifier by virtue of this feedback. The self-oscillation frequency of the loop circuit configured by the comparator 14, the switching circuits 15 and 17, the LPFs 16 and 18, the subtractor 19 and the first feedback circuit 20 can be adjusted by changing the delay amount of the first feedback circuit 20.

Furthermore, according the audio band, the circuit formed by adding the second resistor 13 to this loop circuit operates as a single inverting amplifier in which the output of the subtractor 19 is used as the output of the amplifier and the gain of the amplifier is determined by the resistor 13, the resistor 201 and the subtractor 19. The inverting input terminal of the comparator 14 is grounded virtually. Moreover, since the LPFs 16 and 18 almost remove the carrier component of the power-amplified PWM signal, only a small carrier component is fed back through the first feedback circuit 20. Since no high voltage is applied to the input as described above, an ordinary semiconductor device having a low breakdown voltage can be used as the comparator 14.

The amplifier 10 self-oscillates the PWM signal in the loop circuit starting from the comparator 14, passing through the first and second LPFs 16 and 18 and returning through the subtractor 19 and the first feedback circuit 20 as described above. It is desirable that the frequency characteristics of the loop circuit should keep relatively high gain in a frequency range from the audio band up to a sufficiently high frequency compared to the self-oscillation frequency f0. Otherwise, the self-oscillation may become unstable, for example, the oscillation frequency of the self-oscillation may fluctuate and become unstable. Hence, it is desirable that the frequency characteristics of the operational amplifier 191 of the subtractor 19 should have high gain in the frequency range up to the substantially high frequency. However, the frequency characteristics of ordinary (not special) operational amplifiers are insufficient. As a countermeasure for this problem, the bypass circuit 22 is provided in this embodiment.

The bypass circuit 22 includes, for example, a resistor 221 and a capacitor 222 connected in series. One end of the resistor 221 is connected to the first output terminal 3, and one end of the capacitor 222 on the opposite side of the resistor is connected to the second input terminal of the comparator 14. The order of the resister 221 and the capacitor 222 in the series may be reversed.

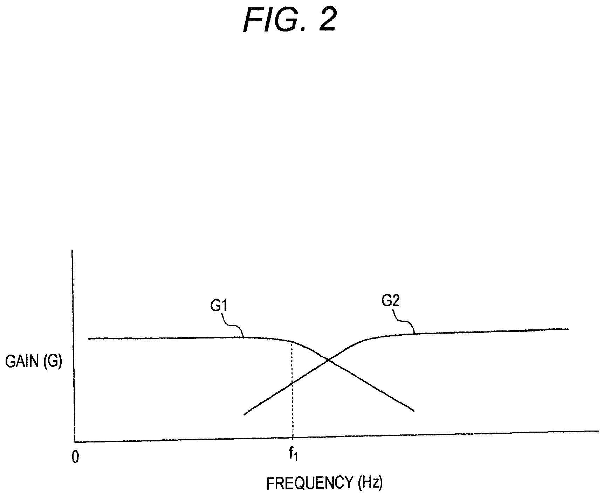

Fig. 2 is a frequency characteristic diagram illustrating the operation of the bypass circuit 22. The horizontal axis represents frequency and the vertical axis represents gain (or attenuation rate). Graph G1 represents the frequency characteristics of a gain of the subtractor 19 formed of an ordinary operational amplifier. The gain remains a substantial value in a frequency range under a first cutoff frequency f1 around 1 MHz to several MHz, which includes the entire audio band, and the gain gradually decreases as the frequency rises further from the frequency f1. Hence, if the self-oscillation is performed in a loop circuit with no bypass circuit, that is, the loop circuit obtained by removing the bypass circuit 22 from the loop circuit shown in Fig. 1, the feedback signal via the first feedback circuit 20 may be insufficient in the sufficiently high frequency, and the self-oscillation may become unstable. The bypass circuit 22 supplies the feedback signal in the sufficiently high frequency to compensate for the insufficient portion of the frequency characteristics of this type of subtractor 19.

Graph G2 in Fig. 2 represents the frequency characteristics of the bypass circuit 22. The gain of the bypass circuit 22 is very low in the low frequency around the audio band, the gain gradually rises as the frequency rises up to a second cutoff frequency f2 around 1 MHz to several MHz and higher than the frequency f1, and the gain remains a substantial value in the higher frequencies than the frequency f2. Although the feedback signal via the subtractor 19 of the first feedback circuit 20 is insufficient in the sufficiently high frequency, by means of the bypass circuit 22, the feedback signal in the sufficiently high frequency is supplied and fed back to the integrated signal on the second input side of the comparator 14 via the bypass circuit 22. The signal fed back through the bypass circuit 22 herein serves as a phase advance compensation signal (feed forward compensation) for advancing the phase of the feedback signal, and this signal compensates for the phase delay in the subtractor 19. As a result, stable self-oscillation can be attained.

The second feedback circuit 21 includes the resistor 211, one end of which is connected to the output of the subtractor 19 and the other end of which is connected to the non-inverting input terminal of the operational amplifier 121 of the integration circuit 12, and also includes the capacitor 212 connected in parallel with the resistor 211. The second feedback circuit 21 feeds back the difference signal coming from the subtractor 19 to the audio signal input to the integration circuit 12. This feedback improves the distortion characteristics of the amplifier 10 in the audio band and determines the gain of the amplifier 10. In the second feedback circuit 21, the capacitor 212 is connected in parallel with the resistor 211, thereby advancing the phase of the feedback signal and stabilizing the operation of the amplifier 10 (phase compensation).

According to the circuit shown in Fig. 1, the non-inverting input terminal of the comparator 14 is grounded, and the voltage of the inverting input terminal of the comparator 14 does not swing so much around the center of the reference voltage. Hence, the comparator 14 is not required to have a high breakdown voltage (±30 V or more) and an ordinary semiconductor device having a low breakdown voltage (±2 to 20 V) can be used as the comparator.

Furthermore, the two BTL-type positive and negative outputs are received by the subtractor 19 (differential amplifier) and fed back as a single signal. Hence, a single self-oscillation loop is formed and the self-oscillation is stabilized easily.

Moreover, since the additional feedback route via the bypass circuit 22 is provided in addition to the feedback route via the subtractor 19 and the first feedback circuit 20, the self-oscillation of the amplifier 10 becomes stable. On the other hand, with respect to the audio band, since the difference signal between the two output signals of the amplifier 10 is obtained by the subtractor 19, and fed back to the input terminal of the integration circuit 12 via the second feedback circuit 21, the distortion characteristics of the amplifier 10 in the audio band is improved.

In the case that a special operational amplifier having high gain in the substantially high frequency is used for the subtractor 19, it is not necessary to provide the bypass circuit 22 in the circuit shown in Fig. 1. Conversely, the circuit provided with the bypass circuit 22 is advantageous in that an ordinary (not special) operational amplifier can be used as the subtractor 19.

Although the bypass is formed from the first output terminal 3 to the second input terminal of the comparator 14 in the circuit shown in Fig. 1, a bypass may be formed from the second output terminal 4 to the first input terminal of the comparator 14 instead.

The specific circuit configurations according to the above-mentioned embodiment are not limited to those described above, but can be modified and implemented as necessary. For example, the configurations of the non-inverting analog integration circuit 12, the first feedback circuit 20, the second feedback circuit 21, the subtractor 19 and the bypass circuit 22 are not exactly limited to those shown in Fig. 1. Differentiation circuits may be used for the first feedback circuit 20 and the second feedback circuit 21.

Here, the details of the above embodiments are summarized as follows.
(1) The disclosure provides a Bridge-Tied Load output self-oscillating class D amplifier comprising:
   a signal input circuit;
   a comparator, having a first input terminal being grounded and an second input terminal, and configured to receive an input signal coming from the signal input circuit at the second input terminal, and output a positive-phase pulse width modulation signal and a reverse-phase pulse width modulation signal with respect to the input signal by comparing voltages of the first input terminal and the second input terminal;
   a first switching circuit configured to power-amplify the reverse-phase pulse width modulation signal;
   a first low-pass filter configured to extract a first output signal from the power-amplified reverse-phase pulse width modulation signal;
   a second switching circuit configured to power-amplify the positive-phase pulse width modulation signal;
   a second low-pass filter configured to extract a second output signal from the power-amplified positive-phase pulse width modulation signal;
   a subtractor configured to calculate a difference between the first output signal and the second output signal and output a difference signal; and
   a first feedback circuit configured to feed back the difference signal to the second input terminal of the comparator to make the amplifier self-oscillate.
(2) For example, the signal input circuit comprises: a first resistor; an integration circuit configured to integrate a signal received through the first resistor and output an integrated signal; a second resistor disposed so as to precede the comparator, and the Bridge-Tied Load output self-oscillating class D amplifier further comprises: a second feedback circuit configured to feed back the difference signal to an input terminal of the integration circuit.
(3) For example, as for the Bridge-Tied Load output self-oscillating class D amplifier above, the difference signal output by the subtractor and fed back by the first feedback circuit contains a high frequency component not enough to make the self-oscillation by the amplifier stable, and the amplifier further comprises: a bypass circuit configured to supply a high frequency component of the first output signal to the second input terminal of the comparator for the stable self-oscilation.

## Claims

1. A Bridge-Tied Load output self-oscillating class D amplifier comprising:
a signal input circuit;
a comparator, having a first input terminal being grounded and an second input terminal, and configured to receive an input signal coming from the signal input circuit at the second input terminal, and output a positive-phase pulse width modulation signal and a reverse-phase pulse width modulation signal with respect to the input signal by comparing voltages of the first input terminal and the second input terminal;
a first switching circuit configured to power-amplify the reverse-phase pulse width modulation signal;
a first low-pass filter configured to extract a first output signal from the power-amplified reverse-phase pulse width modulation signal;
a second switching circuit configured to power-amplify the positive-phase pulse width modulation signal;
a second low-pass filter configured to extract a second output signal from the power-amplified positive-phase pulse width modulation signal;
a subtractor configured to calculate a difference between the first output signal and the second output signal and output a difference signal; and
a first feedback circuit configured to feed back the difference signal to the second input terminal of the comparator to make the amplifier self-oscillate.

2. The Bridge-Tied Load output self-oscillating class D amplifier according to claim 1, wherein the signal input circuit comprises:
a first resistor;
an integration circuit configured to integrate a signal received through the first resistor and output an integrated signal; and
a second resistor disposed so as to precede the comparator,
the Bridge-Tied Load output self-oscillating class D amplifier further comprising:
a second feedback circuit configured to feed back the difference signal to an input terminal of the integration circuit.

3. The Bridge-Tied Load output self-oscillating class D amplifier according to claim 1 or 2, wherein
the difference signal output by the subtractor and fed back by the first feedback circuit contains a high frequency component not enough to make the self-oscillation by the amplifier stable, and
the amplifier further comprising:
a bypass circuit configured to supply a high frequency component of the first output signal to the second input terminal of the comparator for the stable self-oscillation.
